(19) Europäisches Patentamt

European Patent Office

Office européen des brevets

(11) **EP 1 017 966 B1**

(12) **FASCICULE DE BREVET EUROPEEN**

(45) Date de publication et mention
de la délivrance du brevet:
**06.11.2002 Bulletin 2002/45**

(21) Numéro de dépôt: **98945378.2**

(22) Date de dépôt: **25.09.1998**

(51) Int Cl.⁷: **G01D 5/244**, H03M 1/00

(86) Numéro de dépôt international:
**PCT/FR98/02062**

(87) Numéro de publication internationale:
**WO 99/017081 (08.04.1999 Gazette 1999/14)**

(54) **CAPTEUR NUMERIQUE DE POSITION**

DIGITALER POSITIONSGEBER

DIGITAL POSITION SENSOR

(84) Etats contractants désignés:
**DE ES GB IT SE**

(30) Priorité: **26.09.1997 FR 9712033**

(43) Date de publication de la demande:
**12.07.2000 Bulletin 2000/28**

(73) Titulaire: **SNR ROULEMENTS
74010 Annecy Cédex (FR)**

(72) Inventeurs:
• **TRAVOSTINO, Francis
F-74940 Annecy le Vieux (FR)**

• **BOCHET, Alain
F-74600 Seynod (FR)**

(74) Mandataire: **Srour, Elie
Renault,
Technocentre,
S.0267 - TCR AVA 0-56,
1, avenue du Golf
78288 Guyancourt (FR)**

(56) Documents cités:
EP-A- 0 671 605          DE-A- 3 231 990
DE-C- 3 737 720

**Description**

La présente invention concerne un capteur numérique de position, notamment de position absolue, plus particulièrement utilisé dans des roulements capteurs pour des applications automobiles ou industrielles. Un tel capteur peut être monté dans des roulements de colonne de direction de véhicule automobile pour contrôler la trajectoire du véhicule, ou bien encore dans des systèmes de contrôle et de pilotage de la position d'un robot ou d'une machine outil par exemple.

Un capteur de position absolue renseigne très précisément sur la position des organes en mouvement, pour pouvoir notamment les piloter et surtout pour retrouver la position de ces organes dès la mise sous tension du système dans lequel ils sont intégrés. Il présente l'avantage d'éviter une initialisation préliminaire au fonctionnement, en venant par exemple détecter une impulsion de référence comme dans le cas d'un capteur de position relative.

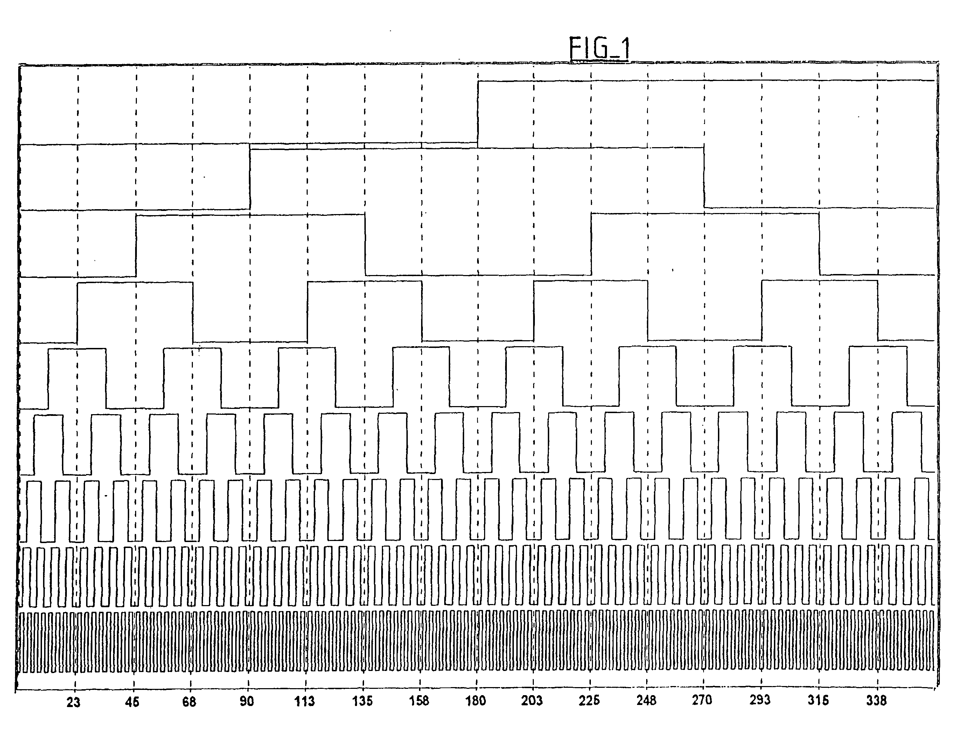

Un capteur de position absolue délivre une pluralité de signaux de sortie dans le cas d'une sortie dite en parallèle, mais dans le cas d'une sortie dite en série, il délivre un seul signal résultant d'une mise en forme conforme à un protocole de transmission de données et réalisée à partir des signaux en parallèle précédemment décrits. Bien que le code fourni par les signaux de sortie pour repérer la position absolue puisse être quelconque, cependant un code binaire ou le code Gray est préférentiellement utilisé. La figure 1 est un exemple de signaux de sortie parallèles codés en code Gray et délivrant 512 points, autrement dit 512 positions différentes par tour.

De plus, dans le cas d'un capteur délivrant un nombre entier positif n de signaux de sortie en parallèle, il y a généralement n pistes différentes portées par le codeur, possédant chacune un codage spécifique et n capteurs fixes destinés à lire les informations fournies par ces n pistes, autrement dit le nombre de capteurs et de pistes codées est égal au nombre de signaux de sortie disponibles permettant d'obtenir une résolution maximale égale à $2^n$.

Ce type de dispositif peut être réalisé à partir d'un codeur optique, utilisant une technologie de gravure des disques permettant d'obtenir une grande finesse de traits. L'avantage d'un tel codeur optique est qu'il délivre des signaux digitaux beaucoup plus fiables que les signaux issus des capteurs analogiques de position absolue de type potentiométrique, en particulier lorsque la température ambiante varie. Cependant, son utilisation est limitée à des applications réalisées dans des ambiances peu sévères, à très faible niveau de pollution et de vibrations, et pour une température ambiante inférieure à 100°C.

Pour repousser ces limites, il existe des codeurs magnétiques, constitués d'un disque magnétique multipiste et multipolaire lié à la partie mobile du dispositif et de plusieurs capteurs magnétiques liés à la partie fixe du dispositif. Sur le disque mobile sont aimantées une pluralité de pistes magnétiques multipolaires, comportant chacune une succession de pôles Nord et Sud équirépartis, qui passent successivement devant des capteurs de type sondes à effet Hall, sondes magnétorésistives ou bien de type inductif. Ces capteurs magnétiques de position peuvent être avantageusement intégrés dans des roulements, comme cela est décrit dans les demandes de brevet français publiées sous les numéros FR 2 678 329 et FR 2 660 028, au nom de la demanderesse.

Par contre, leur principal inconvénient provient de leur encombrement important quand plusieurs pistes magnétiques sont disposées sur le disque, dans le but d'obtenir un codage et des signaux de sortie identiques à ceux obtenus avec un codeur optique de position absolue. En effet, un espacement minimum doit être respecté entre chacune d'elles, afin de réduire leurs influences mutuelles, néfastes à la précision des signaux de sortie représentatifs de la position absolue du système dans lequel est placé le capteur. De plus, l'aimantation multipolaire traditionnelle, obtenue à partir d'un aimanteur bobiné parcouru par de forts courants électriques, est très compliquée.

Il existe cependant des dispositifs magnétiques permettant de résoudre ces problèmes d'encombrement d'une part et d'aimantation d'autre part, constitués d'un disque magnétique en matériau couche mince où la technologie de l'écriture magnétique permet l'écriture d'une très grande densité d'informations, et de capteurs inductifs ou magnétorésistifs adaptés à la lecture des informations codées écrites sur le disque. Leurs inconvénients sont de deux ordres: ils exigent un très faible entrefer de lecture, incompatible avec des conditions d'applications industrielles, et sont relativement fragiles d'utilisation.

On connaît également le document EP-A-0671605 qui décrit un capteur numérique de position angulaire générant des signaux analogiques de sortie après traitement des 2 signaux de sortie sinusoïdaux, et le document WO-9814756 qui décrit dans le même sens un circuit de multiplication de résolution des signaux sinusoïdaux délivrés par au moins deux capteurs analogiques fixes.

Pour pallier aux inconvénients cités précédemment, l'invention propose un capteur numérique de position, dont le dispositif de traitement du signal est capable de générer, à partir seulement de deux signaux d'entrée qui sont issus de deux capteurs et sont de forme sinusoïdale, en quadrature, centrés sur la même valeur moyenne et possédant une période par tour de la partie mobile du capteur, des signaux de sortie identiques à ceux des capteurs digitaux de position absolue.

Pour cela, l'objet de l'invention est un capteur numérique de position, constitué d'une part d'une cible mobile en face d'un capteur analogique fixe composé de deux éléments sensibles délivrant deux signaux de sortie sinusoïdaux, d'amplitudes maximales égales, centrés sur une même valeur moyenne, en quadrature et de période égale à un tour de rotation de la cible, et d'autre part d'un dispositif de traitement des deux signaux de sortie générant n signaux de sortie en parallèle, n étant un entier positif supérieur ou égal à 2,comprenant des moyens de génération, à partir des deux signaux sortie, de $2^{m-1}$ signaux , de même amplitude, centrés sur la même valeur moyenne et successivement déphasés de $2\Pi/2^{m-1}$ les uns par rapport aux autres, m étant un nombre entier positif inférieur ou égal à n, destiné à délivrer la position d'un organe en rotation, solidaire de la cible mobile, avec une résolution égale à $2^n$, caractérisé en ce que le dispositif de traitement comprend, en outre :

- des moyens de détection de $2^m$ secteurs délimités par les $2^{m-1}$ signaux, délivrant m signaux digitaux qui correspondent aux bits de poids forts du signal et qui sont codés de façon à définir les $2^m$ secteurs identiques;
- des moyens de multiplexage analogique des $2^{m-1}$ signaux délivrés par les moyens de génération, commandés par les m signaux digitaux issus des moyens de détection, et délivrant deux signaux, dont l'un est constitué par la succession des portions des $2^{m-1}$ signaux dont l'amplitude est comprise entre la valeur de centrage et un premier seuil, et dont l'autre est constitué par la succession des portions des $2^{m-1}$ signaux dont l'amplitude est comprise entre le premier seuil et un second seuil supérieur au premier ;
- des moyens d'interpolation fine des deux signaux, issus des moyens de multiplexage, dans chacun des $2^m$ secteurs, pour générer (n-m) signaux digitaux qui correspondent aux bits de poids faibles du signal et qui sont codés de façon à découper chacun des $2^m$ secteurs en $2^{n-m}$ sous-secteurs identiques d'angle $2\pi/2^n$ pour obtenir la résolution souhaitée, l'ensemble des signaux digitaux ($b_1$, ..., $b_{n-m}$, $b_{n-m+1}$, .., $b_n$) de sortie du capteur de position étant représentatifs de la position absolue de l'organe en rotation.

D'autres caractéristiques et avantages de l'invention apparaîtront à la lecture de la description suivante, d'un exemple de réalisation non-limitatif, illustrée par les figures suivantes qui sont:

- la figure 1: un exemple des signaux de sortie d'un capteur numérique de position absolue, codés en code Gray;
- la figure 2: une représentation graphique des signaux d'entrée du capteur numérique selon l'invention;
- la figure 3: un schéma électronique fonctionnel d'un capteur numérique de position absolue selon l'invention;
- les figures 4a et 12a: une représentation graphique de différents signaux délivrés par des moyens constitutifs du capteur selon l'invention;
- les figures 4b et 12b: l'ensemble des signaux de sortie d'un capteur de position absolue selon l'invention;
- les figures 5, 6, 7a à 7d, 8, 9, 10 et 11: des schémas de principe d'exemples de réalisation des différents moyens constituant le dispositif de traitement du capteur de position, selon l'invention;
- la figure 13: un schéma électronique fonctionnel d'un capteur numérique de position relative selon l'invention;
- la figure 14: les signaux de sortie d'un capteur de position relative selon l'invention.

Le capteur numérique de position, objet de l'invention, est constitué d'une cible mobile, solidaire de l'organe en rotation dont on cherche à connaître la position, et d'un capteur analogique fixe. Ce capteur est composé de deux éléments sensibles, délivrant deux signaux de sortie $S_1$ et $S_2$, qui sont de forme sinusoïdale, de même amplitude $A_0$, centrés sur la même valeur moyenne $C_0$ et en quadrature l'un par rapport à l'autre. De plus, ils ont une période T égale à un tour de rotation de la cible, soit $2\pi$ mécaniques.

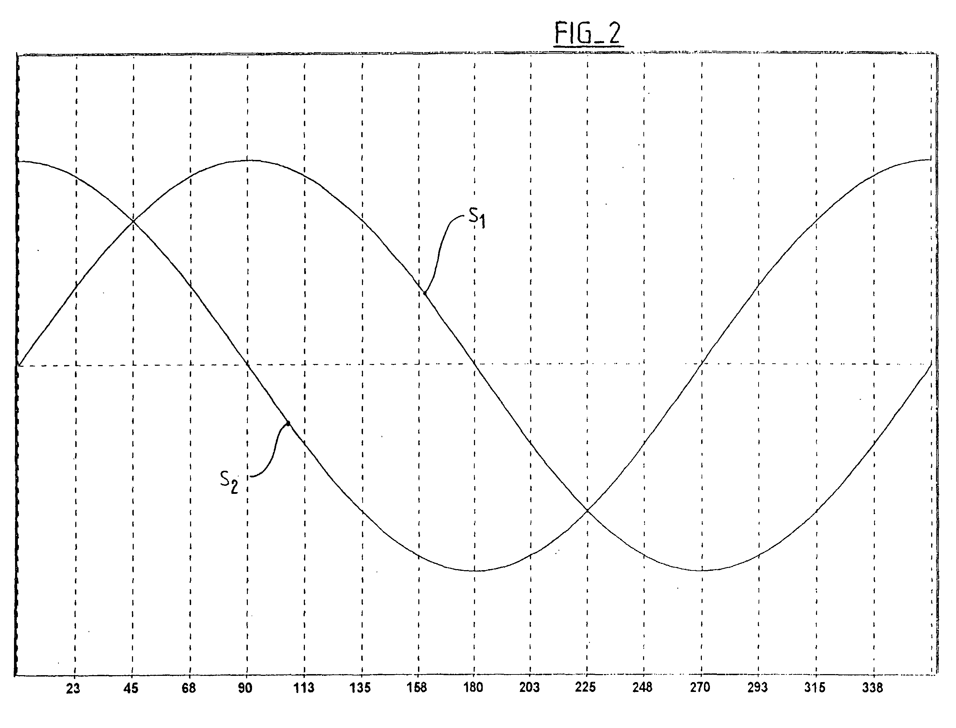

La figure 2 est une représentation graphique de ces deux signaux $s_1$ et $S_2$ issus du capteur magnétique.

La caractéristique principale du capteur numérique selon l'invention est qu'il comporte de plus un dispositif de traitement comprenant des moyens de traitement de ces deux signaux $s_1$ et $S_2$ délivrés par les deux éléments sensibles fixes, permettant d'atteindre une grande résolution par tour. Dans une première partie de la description, le traitement des signaux $S_1$ et $S_2$ permet de générer n signaux digitaux de sortie déterminant la position absolue sur un tour complet de la partie mobile de l'organe en rotation, et dans une seconde partie, le traitement des signaux permet de donner la position relative de cet organe, grâce à trois signaux obtenus à partir des n signaux précédents.

Dans la description qui va suivre d'un exemple particulier de réalisation, le capteur de position permet d'obtenir une résolution de $2^9$ soit 512 points par tour, en générant neuf signaux digitaux de sortie $b_1$ à $b_9$, tels que ceux représentés en code Gray sur la figure 1. Cet exemple numérique n'est pas limitatif et le procédé de traitement des signaux issus des éléments sensibles du capteur permet d'obtenir n'importe quelle valeur de résolution, que ce soit ou non une puissance de deux, et selon n'importe quel code binaire. L'avantage du code Gray déjà mentionné est qu'il ne présente qu'un seul changement d'état sur les neuf signaux de sortie $b_1$ à $b_9$, lors du passage de la cible de la position x à la position x + 1.

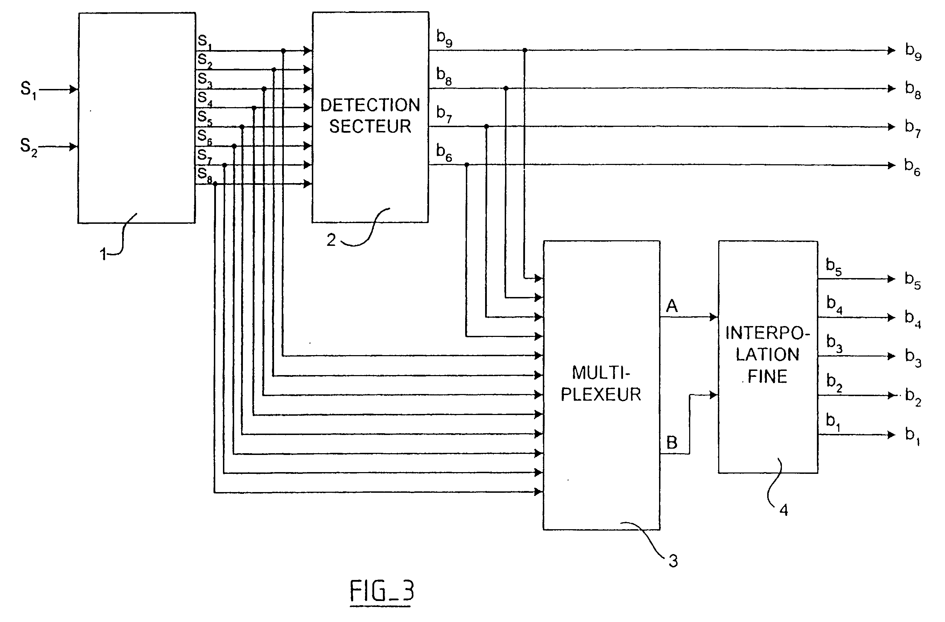

Les moyens de traitement électronique des signaux $S_1$ et $S_2$ issus du capteur de position absolue sont essentiellement au nombre de quatre, dont le schéma électronique fonctionnel est l'objet de la figure 3. Pour obtenir une résolution égale à 2n, n étant un nombre entier positif supérieur ou égal à 2, il se compose tout d'abord de moyens 1 de génération d'un nombre égal à $2^{m-1}$ signaux sinusoïdaux $S_i$, à partir des deux signaux $S_1$ et $S_2$, m étant un nombre entier positif inférieur ou égal à n et i étant un nombre entier positif variant de 1 à $2^{m-1}$.

Les $2^{m-1}$ signaux $S_i$ permettent de délimiter $2^m$ secteurs identiques $P_i$, dans les $2\pi$ radians d'un tour de la cible, de dimension égale à $2\pi/2^m$ radians chacun. Ces signaux $S_i$ sont sinusoïdaux, de même amplitude $A_o$, successivement déphasés de $2\pi/2^{m-1}$ les uns par rapport aux autres. Ils sont obtenus par des combinaisons linéaires simples de $S_1$ et $S_2$, ne mettant en oeuvre que des sommes ou des différences pondérées, dont les combinaisons varient suivant les valeurs de m.

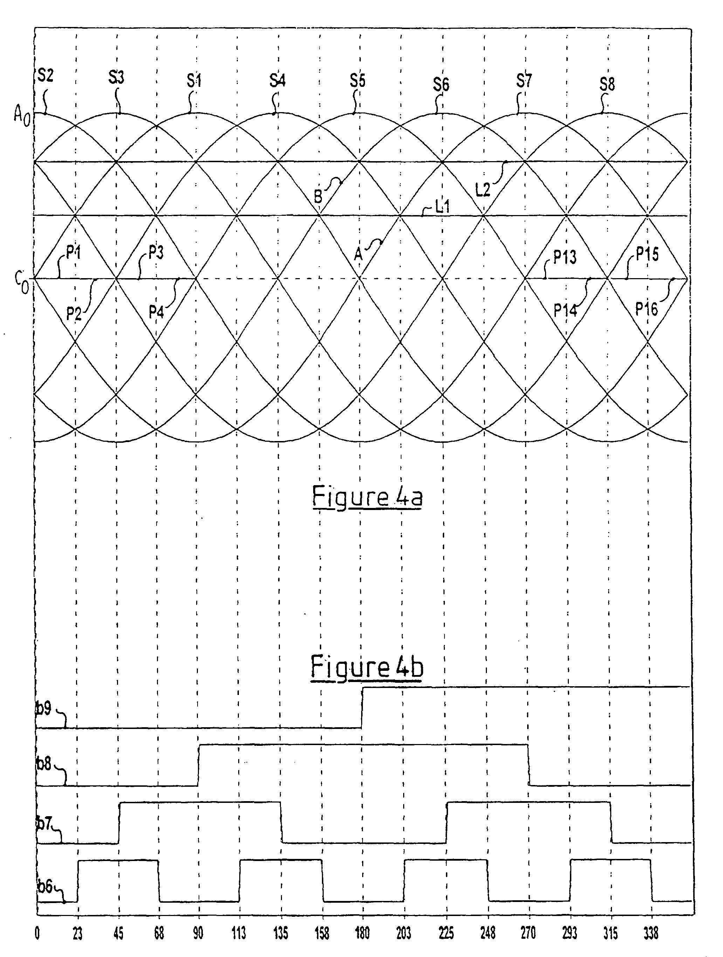

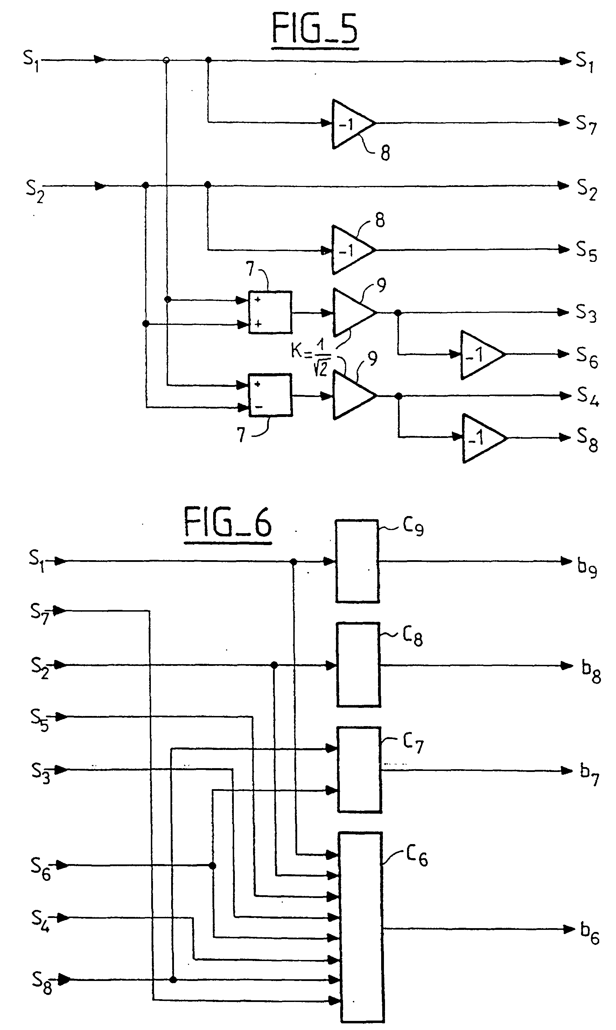

La figure 4a est une représentation graphique des signaux $S_i$ générés à partir des deux signaux $S_1$ et $S_2$, au nombre de $2^{m-1} = 8$, m étant égal à 4 dans l'exemple de réalisation choisi. Ces huit signaux $S_1$ à $S_8$ sont utiles à la définition des seize secteurs $P_1$ à $P_{16}$, et sont déphasés de $2\pi/8$, soit 45° dans cet exemple. La figure 5 est un schéma électronique d'un exemple non limitatif de moyens 1 de génération des huit signaux $S_i$, comprenant des circuits sommateurs 7, des circuits inverseurs 8 et des amplificateurs 9 par des facteurs déterminés K. Dans cet exemple choisi, les signaux ont pour valeurs:

$$S_7 = - S_1$$

$$S_5 = - S_2$$

$$S3 = \frac{S_1 + S_2}{K} = \frac{S_1 + S_2}{\sqrt{2}}$$

$$s_6 = - S_3$$

$$S_4 = \frac{S_1 - S_2}{\sqrt{2}}$$

$$S_8 = - S_4$$

Le capteur de position comporte ensuite des moyens 2 de détection des $2^m$ secteurs $P_i$ délimités par les $2^{m-1}$ signaux $S_i$, délivrant m signaux digitaux $b_{n-m+1}$, $b_{n-m+2}$, ..., $b_{n-1}$, $b_n$ qui correspondent aux bits de poids forts du signal. Les m signaux digitaux sont codés par un code binaire déterminé pour lequel chaque combinaison n'arrive qu'une fois par tour, afin de définir sans ambiguïté les $2^m$ secteurs $P_i$, et sont obtenus par des comparaisons des $2^{m-1}$ signaux $S_i$ entre eux, suivies de combinaisons logiques entre les signaux digitaux issus de ces comparaisons. Ces opérations mettent en oeuvre des comparateurs 10 et des portes logiques 11, de type ET et OU.

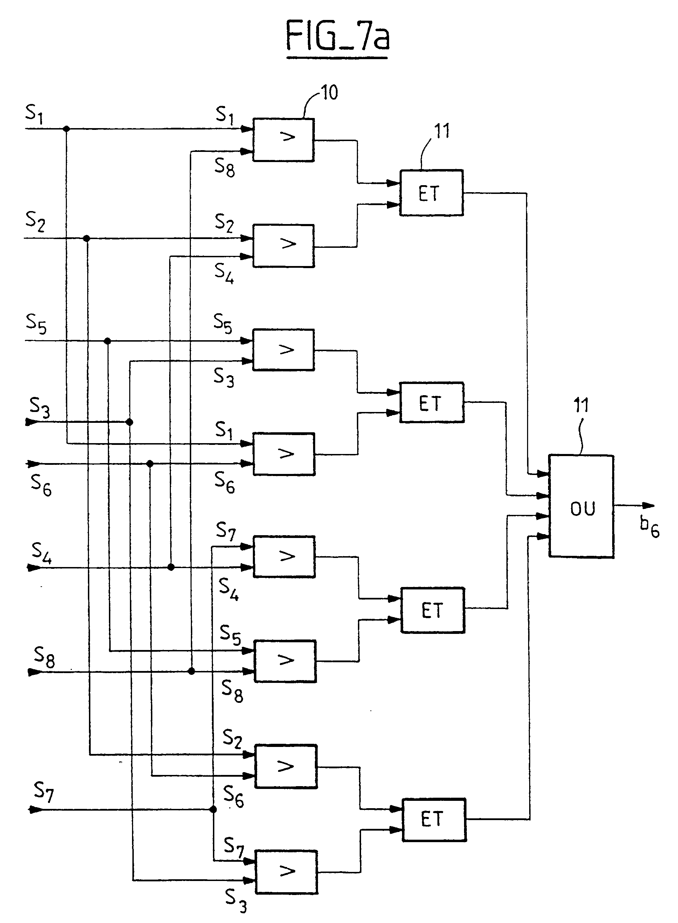

La figure 6 est un schéma électronique d'un exemple non limitatif de réalisation des moyens 2 de détection des seize secteurs, de l'exemple numérique choisi, comprenant essentiellement quatre combinaisons $C_6$ à $C_9$ de comparateurs 10 et de portes logiques 11, délivrant respectivement les signaux digitaux $b_6$ à $b_9$. Chacune de ces combinaisons $C_6$ à $C_9$ est représentée sur les figures 7a à 7d respectivement. Ainsi, comme le montre la figure 7a, la combinaison de circuits $C_6$ délivre le signal numérique référencé $b_6$, qui est égal à 1 si les signaux $S_i$ répondent aux conditions suivantes :

$$b_6 = 1 \text{ si } (S_1 > S_8 \text{ ET } S_2 > S_4) \text{ OU } (S_5 > S_3 \text{ ET } S_1 > S_6) \text{ OU}$$

$$(S_7 > S_4 \text{ ET } S_5 > S_8) \text{ OU } (S_2 > S_6 \text{ ET } S_7 > S_3).$$

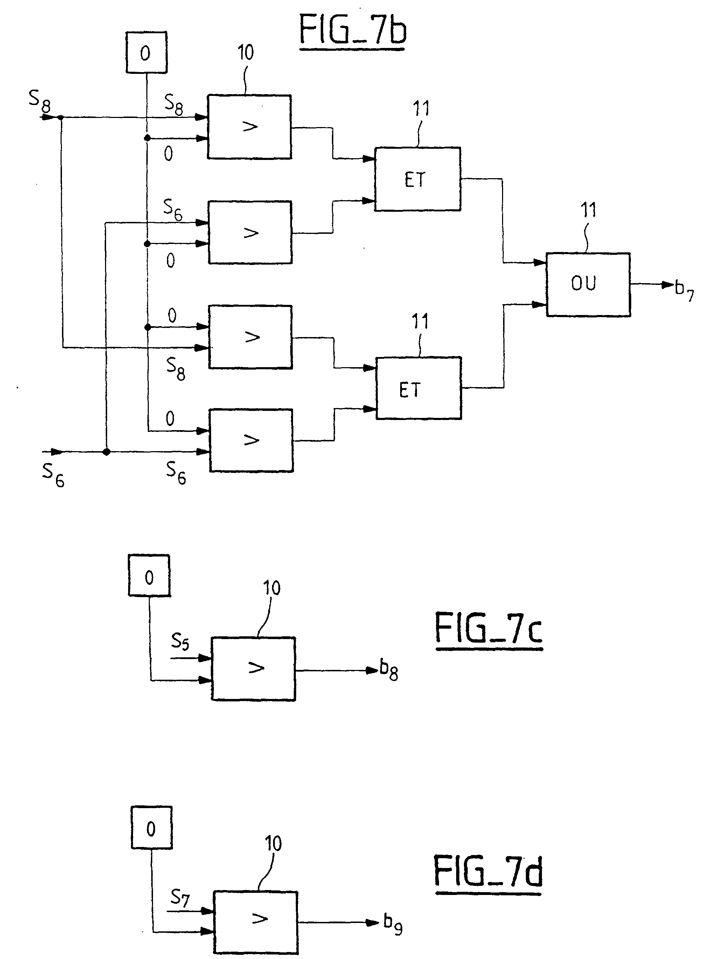

Selon la combinaison $C_7$ de la figure 7b, le signal numérique $b_7$ est tel que :

$$b_7 = 1 \text{ si } (S_3 > 0 \text{ ET } S_4 > 0) \text{ OU } (S_6 > 0 \text{ ET } S_8 > 0).$$

Selon la combinaison $C_8$, représentée sur la figure 7c, le signal binaire $b_8$ est tel que :

$$b_8 = 1 \text{ si } S_5 > 0.$$

Et sur la figure 7d, la combinaison $C_9$ montre que le signal binaire $b_9$ est tel que :

$$b_9 = 1 \text{ Si } S_7 > 0.$$

La figure 4b est une représentation graphique des quatre signaux digitaux $b_6$, $b_7$, $b_8$ et $b_9$, obtenus en sortie des moyens 2 de détection des secteurs, codés en code Gray.

Le traitement électronique des signaux $S_1$ et $S_2$ se poursuit par une étape de génération de deux signaux A et B, utilisés dans une étape suivante d'interpolation fine. Pour cela le capteur de position comprend des moyens 3 de multiplexage analogique des $2^{m-1}$ signaux $S_i$, délivrés par les précédents moyens 1, avec pour signaux de commande les m signaux digitaux $b_{n-m+1}$, $b_{n-m+2}$, .. $b_{n-1}$, $b_n$ délivrés par les précédents moyens 2, et délivrant deux signaux de sortie A et B. L'un des signaux, A, est un signal électrique continu et constitué par la succession des portions des $2^{m-1}$ signaux $S_i$, dont l'amplitude est comprise entre la valeur de centrage C et un premier seuil $L_1$, dont la valeur est choisie égale à $A_0 * \sin(2\pi/2^m)$. Le second signal, B, est également un signal électrique continu et constitué par la succession des portions des $2^{m-1}$ signaux $S_i$ dont l'amplitude est comprise entre le premier seuil L1 et un second seuil $L_2$, de valeur supérieure à $L_1$, et choisie égale à $A_0 * \sin(2\pi/2^{m-1})$.

La figure 4a montre ces deux signaux A et B, dans l'exemple particulier de réalisation où $L_1 = A_0 * \sin 22,5$ et $L_2 = A_0 * \sin 45$, dans le cas où les signaux d'entrée du multiplexeur sont les signaux $S_1$ à $S_8$ et les signaux de commande sont les quatre signaux digitaux $b_6$ à $b_9$.

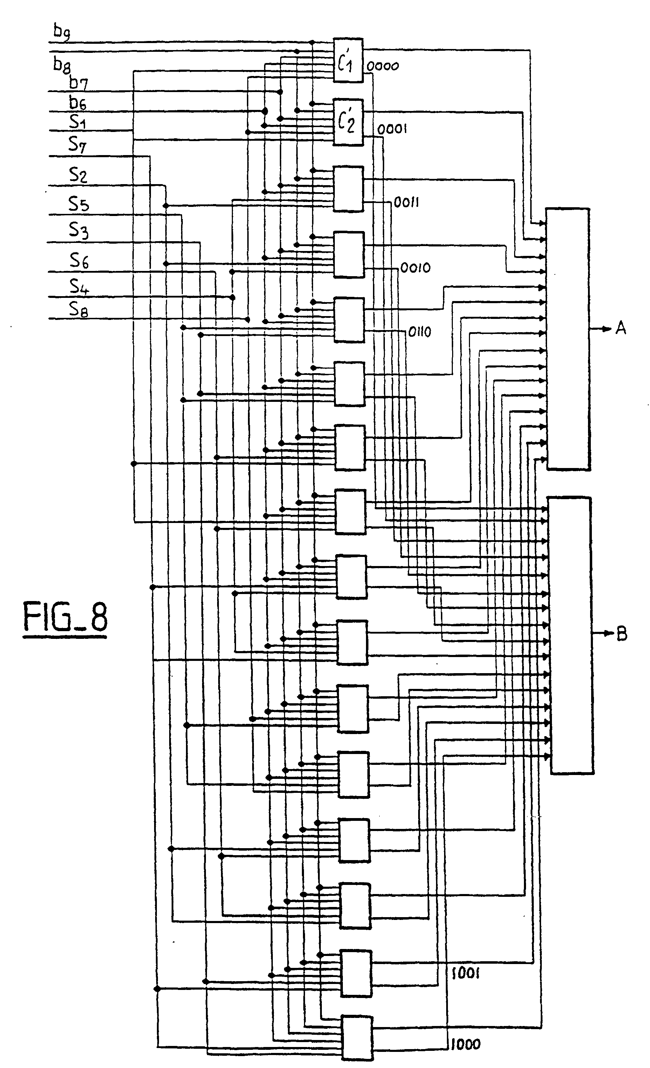

La figure 8 est un schéma électronique d'un exemple de réalisation non limitatif des moyens 3 de multiplexage analogique des huit signaux $S_1$ à $S_8$, par les signaux de commande $b_6$ à $b_9$. Ils comprennent essentiellement $2^m$, soit seize combinaisons $C'_1$ à $C'_{16}$ de circuits logiques, tels que des portes NON ou ET 10, ou des interrupteurs 20, délivrant les signaux A et B.

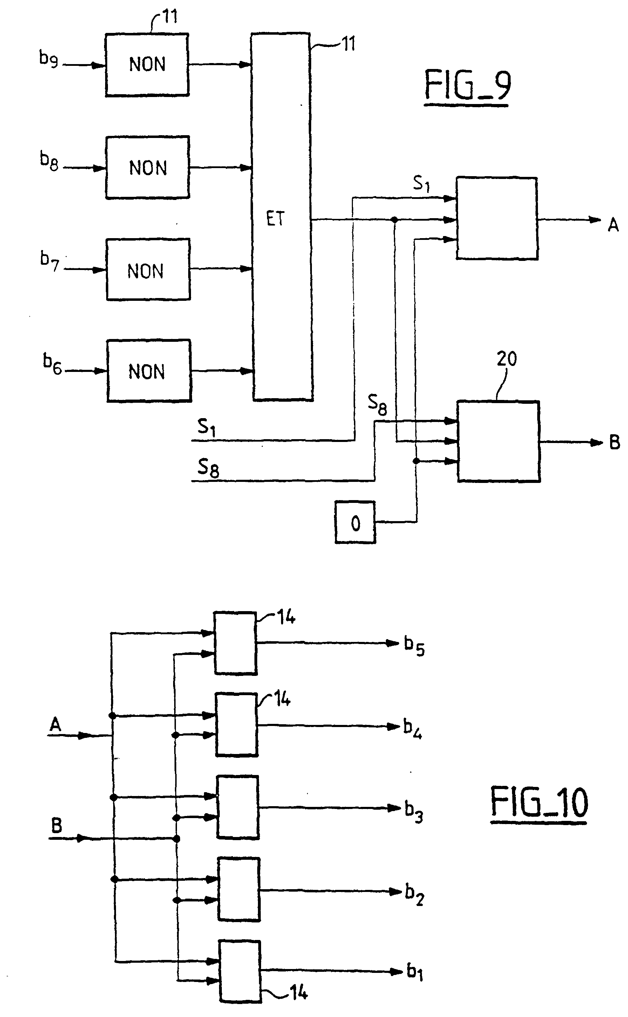

La figure 9 est un exemple de la combinaison $C'_1$, dont les signaux d'entrée sont $S_1$ et $S_8$, délivrant les signaux A et B obtenus par l'équation booléenne suivante :

$$\text{si } \overline{b_6} \text{ ET } \overline{b_7} \text{ ET } \overline{b_8} \text{ ET } \overline{b_9} = 1, \text{ alors } S_1 = A \text{ et } S_8 = B.$$

Le capteur comprend enfin des moyens 4 d'interpolation fine des deux signaux A et B issus des moyens de multiplexage, fonctionnant de façon identique dans chacun des $2^m$ secteurs $P_i$, pour générer (n-m) signaux digitaux de sortie, $b_1$, $b_2$, ... $b_{n-m-1}$ $b_{n-m}$, qui sont les bits de poids faible du signal. Ces signaux digitaux de sortie sont codés de façon à découper chacun des $2^m$ secteurs $P_i$, obtenus précédemment et d'angle $2\pi/2^m$ radians chacun, en $2^{n-m}$ sous secteurs d'angle $2\pi/2^n$ pour obtenir la résolution finale souhaitée.

Pour cela, selon une caractéristique de l'invention, les moyens 4 d'interpolation fine réalisent des atténuations du signal B par des facteurs d'atténuation $k_j$, de valeurs égales à:

$$k_j = -\sin (j * 2\pi/2^n) / \sin (j * 2\pi/2^n - 2\pi/2^{m-1})$$

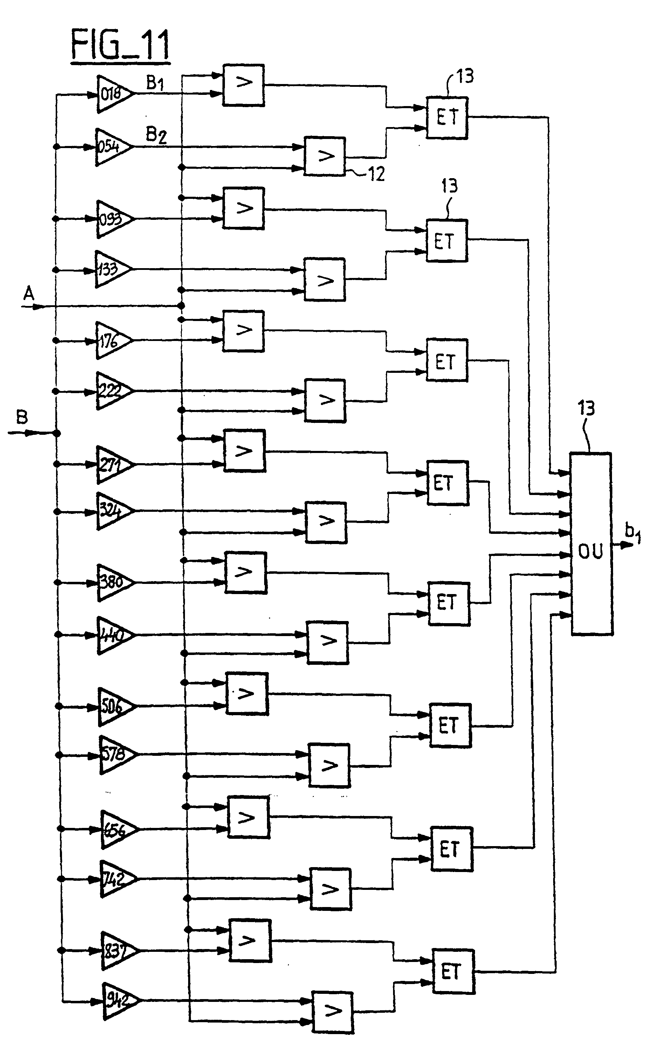

avec j : nombre entier positif variant de 1 à $(2^{n-m} - 1)$ et délivrant des signaux d'atténuation $B_j$. Les atténuations du signal B sont réalisées par des réseaux de résistances électriques combinées pour obtenir les facteurs d'atténuation déterminés. Puis, chaque signal $B_j$ est comparé au signal A, dans chaque secteur $P_i$, et leur intersection correspond à une transition bien définie d'un des (n-m) signaux digitaux de sortie $b_1$, $b_2$, ... $b_{n-m-1}$, $b_{n-m}$, dont le codage est identique sur chacun des $2^m$ secteurs $P_i$. L'obtention de l'intersection entre le signal A et chaque signal $B_j$ est réalisée par l'intermédiaire de comparateurs 12 et de portes logiques 13, réalisant des combinaisons logiques 14 entre les signaux digitaux issus de ces comparaisons, comme le montrent les figures 10 et 11, qui sont respectivement un schéma électronique d'un exemple de réalisation de moyens 4 d'interpolation fine délivrant les cinq signaux binaires $b_1$ à $b_5$ de sortie, et un schéma d'un ensemble de circuits électroniques délivrant le signal binaire $b_1$ à partir des deux signaux A et B.

Dans le cas particulier de réalisation choisi, pour lequel la résolution finale souhaitée est de 512 points par tour, l'étape de traitement du signal, qui a permis de découper le signal sur une période de $2\pi$ radians en seize secteurs identiques $P_1$ à $P_{16}$ de 22,5° chacun, est suivie par une étape consistant à découper chaque secteur $P_i$ en 32 sous-secteurs, d'angle égal à 360/512 = 0,703° chacun.

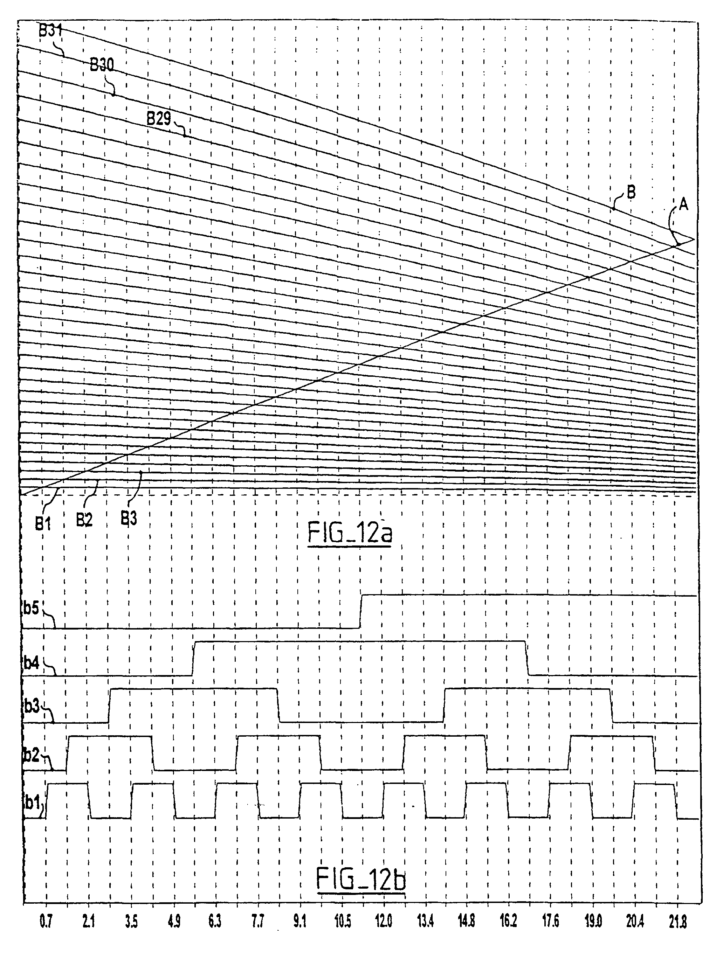

La figure 12a est une représentation graphique agrandie du secteur $P_1$, compris entre 0° et 22,5°, sur lequel sont représentés les signaux A et B d'une part, et les $(2^{n-m} - 1)$ , soit 31 signaux $B_1$ à $B_{31}$ d'autre part.

La figure 12b est la représentation graphique des cinq signaux digitaux $b_1$ à $b_5$.

Ainsi, comme on le voit sur la figure 3, le dispositif de traitement des deux signaux sinusoïdaux $S_1$ et $S_2$ génère les m bits de poids fort du signal de sortie du capteur de position, référencés de $b_{n-m+1}$ à $b_n$, ainsi que les n-m bits de poids faible référencés de $b_1$ à $b_{n-m}$, qui déterminent la position absolue sur $2\pi$ de la partie mobile dudit capteur solidaire de l'organe en rotation.

Le principal avantage du dispositif de traitement des signaux délivrés par deux capteurs fixes, face à la cible mobile du capteur de position selon l'invention, réside dans le fait que chacun des fronts des n signaux $b_1$ à $b_n$ de sortie est généré par comparaison ratiométrique entre deux signaux, ce qui permet de s'affranchir des éventuelles variations d'amplitude des signaux d'entrée $S_1$ et $S_2$, dues par exemple aux variations de température.

De plus, la position de chacun des fronts est définie sans ambiguïté par l'intermédiaire des facteurs d'atténuation $k_j$, caractéristiques de l'invention et qui sont déterminés pour se suivre de façon monotone et régulière quand l'indice j augmente. Cela permet de s'assurer de la position délivrée par le capteur, car un front quelconque représentant la position x de ce dernier est toujours placé entre le front représentant la position x-1 et le front représentant la position x+1, quelque soit x. En aucun cas, un front représentant la position x ne peut arriver après un front représentant la position x+1. Aucune perte d'information, c'est-à-dire aucune perte d'impulsion n'est possible. Cela autorise des signaux d'entré $S_1$ et $S_2$ du dispositif de traitement acceptant certaines tolérances, par exemple dont les amplitudes ou les valeurs moyennes peuvent ne pas être identiques et dont la quadrature peut ne pas être parfaite, comme cela peut survenir dans le cas d'une fabrication ou d'un assemblage industriel.

Selon une première variante du capteur de position de l'invention, ce dernier peut donner la position semi-absolue de l'organe auquel il est fixé, c'est-à-dire absolue dans une période sans repérage de la période dans le tour de rotation, à partir de deux éléments sensibles délivrant deux signaux de sortie $S_1$ et $S_2$ sinusoïdaux, d'amplitudes maximales égales $A_0$, centrés sur une même valeur moyenne $C_0$, en quadrature et de période égale à $2k\pi$ tour de rotation de la cible, k étant un nombre entier positif supérieur ou égal à 2, les moyens constituant le dispositif de traitement étant identiques aux moyens décrits pour obtenir la position absolue.

Selon une deuxième variante du capteur selon l'invention, il peut donner la position relative de l'organe en rotation à partir d'une transformation des n signaux digitaux parallèles $b_i$ de sortie du capteur, donnant la position absolue selon les caractéristiques précédemment décrites, en trois signaux $b_1$, $b_{QUAD}$ et $b_{TT}$.

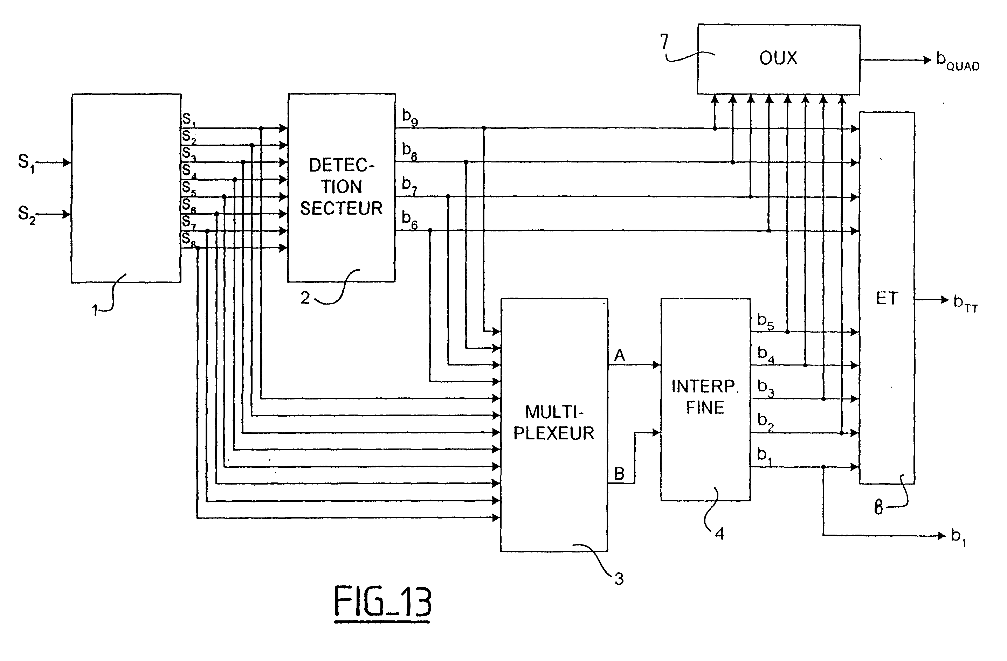

Comme le montre la figure 13, qui est un schéma électronique d'un exemple de réalisation non limitatif, dans le cas d'une résolution égale à $2^9$, le dispositif de traitement comporte de plus des moyens 7 de génération d'un signal de sortie numérique $b_{QUAD}$, de même résolution que le signal numérique $b_1$ de sortie, et en quadrature avec celui-ci, ainsi que des moyens 8 de génération d'une impulsion -de référence $b_{TT}$. Ces moyens se composent chacun de circuits logiques, le premier étant un circuit OU Exclusif sur tous les signaux de sortie, excepté le signal $b_1$ représentant le bit de poids le plus faible, c'est-à-dire sur les n-1 signaux $b_2$ à $b_n$, pour générer le signal de sortie numérique $b_{QUAD}$ en quadrature parfaite avec ledit signal $b_1$, et de même résolution que lui, et le second étant un circuit de référence "top tour" recevant en entrée les n signaux $b_i$ et générant une impulsion unique de référence $b_{TT}$ par tour, appelée signal "top tour". Ce dernier circuit est aisément réalisé à partir d'une combinaison logique des n signaux logiques $b_i$ venant repérer un état bien particulier de l'ensemble des n signaux de sortie $b_i$, par exemple lorsqu'ils sont tous à l'état logique 1, ou à l'état logique 0. Cette combinaison logique des signaux digitaux $b_i$ est obtenue à l'aide de plusieurs portes logiques ET et NON, effectuant par exemple l'opération booléenne suivante :

$$b_{TT} = b_1 \text{ ET } b_2 \text{ ET } ... \text{ ET } b_{n-1} \text{ ET } b_n.$$

Quant au signal de sortie $b_{QUAD}$, il est obtenu à partir d'une combinaison logique des n-1 signaux de sortie digitaux de $b_2$ à $b_n$. Cette combinaison logique des signaux $b_i$ est obtenue à l'aide de plusieurs portes logiques OU Exclusif (OUX) effectuant l'opération booléenne suivante :

$$b_{QUAD} = b_2 \text{ OUX } b_3 \text{ OUX } ... \text{ OUX } b_{n-1} \text{ OUX } b_n.$$

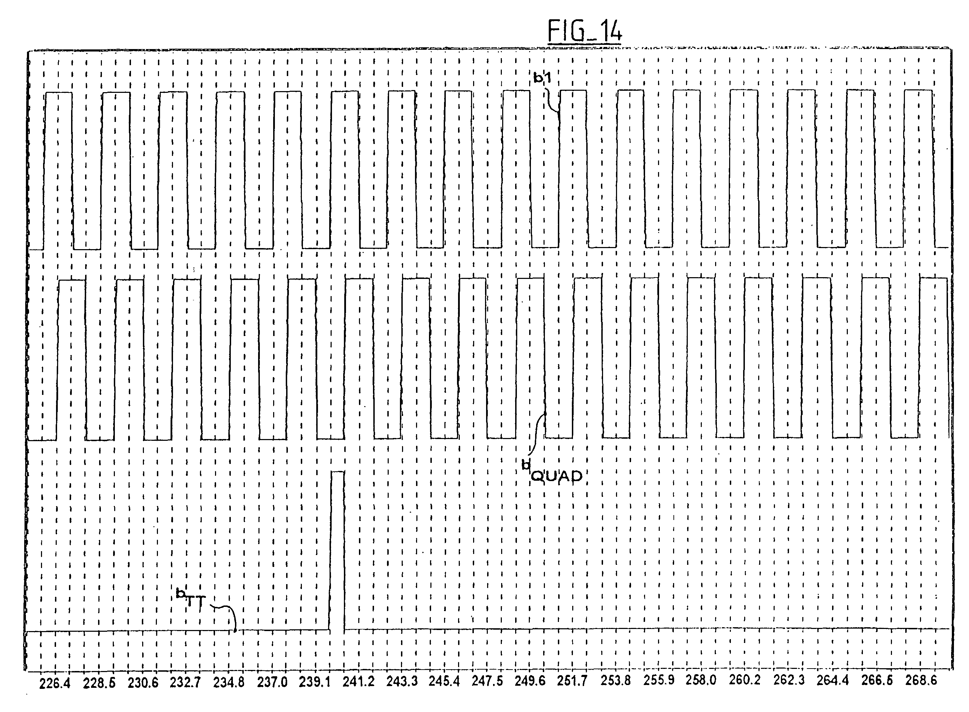

Un exemple de signaux de sortie ainsi obtenus est représenté sur la figure 14.

Le capteur de position, qu'elle soit absolue ou relative, qui vient d'être décrit, peut utiliser tout autre système de codage autre que le code Gray. Il peut également être utilisé avec un codeur magnétique multipolaire, possédant une pluralité de pôles Nord et Sud par tour de rotation, dans le cas où on souhaite réaliser un capteur semi-absolu, c'est-à-dire absolu dans une période sans que cette période soit reconnaissable.

De plus, la sérialisation des n signaux digitaux de sortie $b_1$ à $b_n$ sur un fil peut également être envisagée par l'intermédiaire d'un protocole de transmission de données intégré au dispositif de traitement pour améliorer éventuellement le dispositif de traitement du signal.

**Revendications**

**1.** Capteur numérique de position, constitué d'une part d'une cible mobile en face d'un capteur analogique fixe composé de deux éléments sensibles délivrant deux signaux de sortie ($S_1$ et $S_2$) sinusoïdaux, d'amplitudes maximales égales ($A_0$), centrés sur une même valeur moyenne ($C_0$), en quadrature et de période égale à un tour de rotation de la cible, et d'autre part d'un dispositif de traitement des deux signaux de sortie ($S_1$ et $S_2$) générant n signaux digitaux de sortie en parallèle, n étant un entier positif supérieur ou égal à 2, comprenant des moyens (1) de génération, à partir des deux signaux d'entrée ($S_1$ et $S_2$), de $2^{m-1}$ signaux ($S_i$), i étant un nombre entier positif variant de 1 à $2^{m-1}$, de même amplitude ($A_0$), centrés sur la même valeur moyenne ($C_0$) et successivement déphasés de $2\pi/2^{m-1}$ les uns par rapport aux autres, m étant un nombre entier positif inférieur ou égal à n, destiné à délivrer la position d'un organe en rotation solidaire de la cible mobile, avec une résolution égale à $2^n$, **caractérisé en ce que** le dispositif de traitement comprend:

- des moyens (2) de détection de $2^m$ secteurs ($P_i$) délimités par les $2^{m-1}$ signaux ($S_i$), délivrant m signaux digitaux ($b_{n-m+1}$, $b_{n-m+2}$, .../ $b_{n-1}$, bn) qui correspondent aux bits de poids forts du signal numérique de sortie du capteur et qui sont codés de façon à définir les $2^m$ secteurs identiques ($P_i$);
- des moyens (3) de multiplexage analogique des $2^{m-1}$ signaux ($S_i$) délivrés par les moyens (1) de génération, commandés par les m signaux digitaux ($b_{n-m+1}$, $b_n$) issus des moyens (2) de détection, et délivrant deux signaux (A et B), dont l'un (A) est signaux ($S_i$) dont l'amplitude est comprise entre la valeur de centrage ($C_0$) et un premier seuil ($L_1$), et dont l'autre (B) est constitué par la succession des portions des $2^{m-1}$ signaux ($S_i$) dont l'amplitude est comprise entre le premier seuil ($L_1$) et un second seuil ($L_2$), supérieur à ($L_1$);
- des moyens (4) d'interpolation fine des deux signaux (A et B), issus des moyens (3) de multiplexage, dans chacun des $2^m$ secteurs ($P_i$), pour générer (n-m) signaux digitaux ($b_1$, $b_2$, ... $b_{n-m-1}$, $b_{n-m}$) qui correspondent aux bits de poids faibles du signal et qui sont codés de façon à découper chacun des $2^m$ secteurs ($P_i$) d'angle $2\pi/2^m$ en $2^{n-m}$ sous-secteurs identiques d'angle $2\pi/2^n$ pour obtenir la résolution souhaitée, l'ensemble des signaux digitaux ($b_1$, ..., $b_{n-m}$, $b_{n-m+1}$, ..., $b_n$) de sortie du capteur de position étant représentatifs de la position absolue de l'organe en rotation.

**2.** Capteur numérique de position, constitué d'une part d'une cible multipolaire mobile en face d'un capteur analogique fixe composé de deux éléments sensibles délivrant deux signaux de sortie ($S_1$ et $S_2$) sinusoïdaux, d'amplitudes maximales égales ($A_0$), centrés sur une même valeur moyenne ($C_0$), en quadrature et de période égale à $2k\pi$ tour de rotation de la cible, k étant un nombre entier positif supérieur ou égal à 2, et d'autre part d'un dispositif de traitement des deux signaux de sortie ($S_1$ et $S_2$) générant n signaux digitaux de sortie en parallèle, n étant un entier positif supérieur ou égal à 2, comprenant des moyens (1) de génération, à partir des deux signaux d'entrée ($S_1$ et $S_2$), d'un nombre égal à $2^{m-1}$ de signaux ($S_i$), i étant un nombre entier positif variant de 1 à $2^{m-1}$, de même amplitude ($A_0$), centrés sur le même valeur moyenne ($C_0$) et successivement déphasés de $2\pi/2^{m-1}$ les uns par rapport aux autres, m étant un nombre entier positif inférieur ou égal à n, destiné à délivrer la position d'un organe en rotation solidaire de la cible mobile, avec une résolution égale à $2^n$, **caractérisé en ce que** le dispositif de traitement comprend, en outre:

- des moyens (2) de détection de $2^m$ secteurs ($P_i$) délimités par les $2^{m-1}$ signaux ($S_i$), délivrant m signaux digitaux ($b_{n-m+1}$, $b_{n-m+2}$, ..., $b_{n-1}$, $b_n$) qui correspondent aux bits de poids forts du signal numérique de sortie du capteur et qui sont codés de façon à définir les $2^m$ secteurs identiques ($P_i$);
- des moyens (3) de multiplexage analogique des $2^{m-1}$ signaux ($S_i$) délivrés par les moyens (1) de génération, commandés par les m signaux digitaux ($b_{n-m+1}$, $b_n$) issus des moyens (2) de détection, et délivrant deux signaux (A et B), dont l'un (A) est constitué par la succession des portions des $2^{m-1}$ signaux ($S_i$) dont l'amplitude est comprise entre la valeur de centrage ($C_0$) et un premier seuil ($L_1$), et dont l'autre (B) est constitué par la succession des portions des $2^{m-1}$ signaux ($S_i$) dont l'amplitude est comprise entre le premier seuil ($L_1$) et un second seuil ($L_2$), supérieur au premier ($L_1$);
- des moyens (4) d'interpolation fine des deux signaux (A et B), issus des moyens (3) de multiplexage, dans chacun des $2^m$ secteurs ($P_i$), pour générer (n-m) signaux digitaux ($b_1$, $b_2$, ... $b_{n-m-1}$, $b_{n-m}$) qui correspondent aux bits de poids faibles du signal numérique de sortie et qui sont codés de façon à découper chacun des $2^m$ secteurs ($P_i$) d'angle $2\pi/2^m$ en $2^{n-m}$ sous-secteurs identiques d'angle $2\pi/2^n$ pour obtenir la résolution souhaitée, l'ensemble des signaux digitaux ($b_1$, ..., $b_{n-m}$, $b_{n-m+1}$ ..., $b_n$) de sortie du capteur de position étant représentatifs de la position semi-absolue de l'organe en rotation.

**3.** Capteur numérique de position relative d'un organe en rotation, comprenant un dispositif de traitement selon la revendication 1, **caractérisé en ce que** le dispositif de traitement comprend de plus :

- des moyens (7) de génération d'un signal numérique de sortie ($b_{QUAD}$), en quadrature avec le signal numérique de sortie ($b_1$) correspondant au bit de poids le plus faible du signal de sortie du capteur numérique de position, et de même résolution que celui-ci ;
- des moyens (8) de génération d'une impulsion de référence ($b_{TT}$),

   lesdits signaux digitaux ($b_1$), ($b_{QUAD}$) et ($b_{TT}$) donnant la position relative de l'organe en rotation.

**4.** Capteur numérique de position selon l'une des revendications 1, 2 ou 3, **caractérisé en ce que** les moyens (3) de multiplexage analogique génèrent les signaux (A et B) à partir des seuils ($L_1$) et ($L_2$) de valeurs déterminées :

$$L_1 = A_0 * \sin(2\pi/2^m)$$

$$L_2 = A_0 * \sin(2\pi/2^{m-1})$$

**5.** Capteur numérique de position selon la revendication 4, **caractérisé en ce que** les moyens (3) de multiplexage analogique comprennent $2^m$ combinaisons de circuits logiques, tels que des portes (11) NON et ET.

**6.** Capteur numérique de position selon l'une des revendications 1, 2 ou 3, **caractérisé en ce que** les moyens (4) d'interpolation fine génèrent des signaux ($B_j$), j étant un nombre entier variant de 1 à ($2^{n-m}-1$), qui sont des atténuations du signal (B) par des facteurs d'atténuation ($k_j$), de valeurs égales à :

$$k_j = -\sin(j*2\pi/2^n)/\sin(j*2\pi/2^n - 2\pi/2^{m-1})$$

comparent chaque signal ($B_j$) au signal (A), puis réalisent des combinaisons logiques des signaux digitaux issus de ces comparaisons, pour délivrer les (n-m) signaux de sortie digitaux ($b_1$, $b_2$, ..., $b_{n-m-1}$, $b_{n-m}$) correspondant aux bits de poids faibles du signal.

**7.** Capteur numérique de position selon l'une des revendications 1, 2 ou 3, destiné à délivrer la position d'un organe en rotation avec une résolution égale à $2^9$, **caractérisé en ce que** les moyens (1) de génération des signaux ($S_i$) du dispositif de traitement génèrent $2^{m-1} = 8$ signaux ($S_1$ à $S_8$), déphasés de 45° les uns par rapport aux autres, ayant pour valeurs :

$$S_7 = -S_1$$

$$S_5 = -S_2$$

$$S_3 = \frac{S_1 + S_2}{\sqrt{2}}$$

$$S_6 = -S_3$$

$$S_4 = \frac{S_1 - S_2}{\sqrt{2}}$$

$$S_8 = -S_4$$

obtenues à partir de circuits sommateurs (7), de circuits inverseurs (8) et d'amplificateurs (9).

**8.** Capteur numérique de position, selon la revendication 7, **caractérisé en ce que** les moyens (2) de détection des $2^m = 16$ secteurs ($P_i$) comprennent quatre combinaisons ($C_6$ à $C_9$) de comparateurs (10) et de portes logiques (11) de type ET et OU, délivrant les signaux digitaux suivants :

$$b_9 = 1 \text{ si } S_7 > 0,$$

$$b_8 = 1 \text{ si } S_5 > 0,$$

$$B_7 = 1 \text{ si } (S_3 > 0 \text{ ET } S_4 > 0) \text{ OU } (S_6 > 0 \text{ ET } S_8 > 0),$$

$$b_6 = 1 \text{ si } (S_1 > S_8 \text{ ET } S_2 > S_4) \text{ OU } (S_5 > S_3 \text{ ET } S_1 > S_6)$$

$$\text{OU } (S_7 > S_4 \text{ ET } S_5 > S_8) \text{ OU } (S_2 > S_6 \text{ ET } S_7 > S_3).$$

**9.** Capteur numérique de position relative selon la revendication 3, **caractérisé en ce que** les moyens (7) de génération d'un signal numérique de sortie ($b_{QUAD}$) effectuent l'opération booléenne suivante, à partir de l'opérateur logique OU Exclusif (OUX) :

$$b_{QUAD} = b_2 \text{ OUX } b_3 \text{ OUX } ... \text{ OUX } b_{n-1} \text{ OUX } b_n.$$

**10.** Capteur numérique de position relative selon la revendication 3, **caractérisé en ce que** les moyens (8) de génération d'une impulsion de référence ($b_{TT}$) effectuent l'opération booléenne suivante :

$$b_{TT} = b_1 \text{ ET } b_2 \text{ ET } ... \text{ ET } b_{n-1} \text{ ET } b_n.$$

**11.** Capteur numérique de position relative selon les revendications 9 et 10, **caractérisé en ce que** les moyens (7) de génération d'un signal numérique de sortie ($b_{QUAD}$) sont constitués par un circuit logique OU Exclusif recevant en entrée les signaux digitaux de sortie ($b_2$ à $b_n$), excepté le signal ($b_1$) correspondant au bit de poids le plus faible du signal de sortie du capteur numérique de position, et **en ce que** les moyens (8) de génération d'une impulsion de référence ($b_{TT}$) sont constitués par plusieurs portes logiques ET et NON.

**12.** Capteur numérique de position selon la revendication 6, **caractérisé en ce que** les moyens (4) d'interpolation fine comprennent des réseaux résistifs atténuateurs du signal (B).

**13.** Capteur numérique de position selon l'une des revendications 1, 2 ou 3, **caractérisé en ce que** les n signaux digitaux ($b_i$) de sortie sont sérialisés par l'intermédiaire d'un protocole de transmission de données intégré au dispositif de traitement.

**14.** Capteur numérique de position selon l'une des revendications 1 ou 2, **caractérisé en ce que** le codage des n signaux digitaux de sortie ($b_1$ à $b_n$) permet de définir sans ambigüité la position absolue du capteur.

**Patentansprüche**

**1.** Numerischer Positionssensor, gebildet einerseits aus einem beweglichen Ziel gegenüber von einem fixen analogen Sensor, der aus zwei empfindlichen Elementen gebildet ist, die zwei sinusförmige Ausgangssignale ($S_1$ und $S_2$) liefern, die gleiche maximale Amplituden ($A_0$) aufweisen, auf einen gleichen Mittelwert ($C_0$) zentriert sind, um 90° phasenverschoben sind und eine Periode aufweisen, die gleich einer Umdrehung des Ziels ist, und andererseits aus einer Vorrichtung zur Verarbeitung der zwei Ausgangssignale ($S_1$ und $S_2$), die n parallele digitale Ausgangssignale erzeugt, wobei n eine positive ganze Zahl größer als oder gleich 2 ist, umfassend Mittel (1) zur Erzeugung, ausgehend von den zwei Eingangssignalen ($S_1$ und $S_2$), von $2^{m-1}$ Signalen ($S_i$), wobei i eine positive ganze Zahl von 1 bis $2^{m-1}$ ist, die die gleiche Amplitude ($A_0$) aufweisen, auf den gleichen Mittelwert ($C_0$) zentriert sind und nacheinander um $2\pi/2^{m-1}$ in Bezug aufeinander phasenverschoben sind, wobei m eine positive ganze Zahl kleiner als oder gleich n ist, dazu bestimmt, mit einer Auflösung gleich $2^n$ die Position eines rotierenden Organs zu liefern, das fest mit dem beweglichen Ziel verbunden ist, **dadurch gekennzeichnet, dass** die Vorrichtung zur Verarbeitung umfasst:

- Mittel (2) zur Erfassung von $2^m$ Sektoren ($P_i$,), abgegrenzt durch die $2^{m-1}$ Signale ($S_i$), die m digitale Signale ($b_{n-m+1}$, $b_{n-m+2}$, ..., $b_{n-1}$, $b_n$) liefern, die den werthohen Bits des numerischen Ausgangssignals des Sensors entsprechen und die so codiert sind, dass sie die $2^m$ identischen Sektoren ($P_i$) definieren;

- Mittel (3) zum analogen Multiplexen der von den Erzeugungsmitteln (1) gelieferten $2^{m-1}$ Signale ($S_i$), die von den m digitalen Signalen ($b_{n-m+1}$, $b_n$) gesteuert werden, die von den Erfassungsmitteln (2) ausgegeben werden, und die zwei Signale (A und B) liefern, von denen das eine (A) gebildet wird durch die Aufeinanderfolge der Anteile der $2^{m-1}$ Signale ($S_i$), deren Amplitude zwischen dem Zentrierwert ($C_0$) und einem ersten Schwellenwert liegt ($L_1$) und von denen das andere (B) gebildet wird durch die Aufeinanderfolge der Anteile der $2^{m-1}$ Signale ($S_i$), deren Amplitude zwischen dem ersten Schwellenwert ($L_1$) und einem zweiten Schwellenwert ($L_2$) liegt, der höher ist als der erste ($L_1$);

- Mittel (4) zur Feininterpolation der zwei Signale (A und B), die von den Mitteln (3) zum Multiplexen ausgegeben wurden, in jedem der $2^m$ Sektoren ($P_i$), um (n-m) digitale Signale ($b_1$, $b_2$, ..., $b_{n-m-1}$, $b_{n-m}$) zu erzeugen, die den wertniedrigen Bits des Signals entsprechen und die so codiert sind, dass sie jeden der $2^m$ Sektoren ($P_i$) mit einem Winkel von $2\pi/2^m$ in $2^{n-m}$ identische Untersektoren mit einem von Winkel $2\pi/2^n$ aufteilen, um die gewünschte Auflösung zu erzielen, wobei alle digitalen Ausgangssignale ($b_1$, ..., $b_{n-m}$, $b_{n-m+1}$, ..., $b_n$) des Positionssensors repräsentativ sind für die absolute Position des rotierenden Organs.

2. Numerischer Positionssensor, gebildet einerseits aus einem beweglichen vielpoligen Ziel gegenüber von einem fixen analogen Sensor, der aus zwei empfindlichen Elementen gebildet ist, die zwei sinusförmige Ausgangssignale ($S_1$ und $S_2$) liefern, die gleiche maximale Amplituden ($A_0$) aufweisen, auf einen gleichen Mittelwert ($C_0$) zentriert sind, um 90° phasenverschoben sind und eine Periode aufweisen, die gleich Zkn Umdrehungen des Ziels ist, wobei k eine positive ganze Zahl größer als oder gleich 2 ist, und andererseits aus einer Vorrichtung zur Verarbeitung der zwei Ausgangssignale ($S_1$ und $S_2$), die n parallele digitale Ausgangssignale erzeugt, wobei n eine positive ganze Zahl größer als oder gleich 2 ist, umfassend Mittel (1) zur Erzeugung, ausgehend von den zwei Eingangssignalen ($S_1$ und $S_2$), einer Anzahl gleich $2^{m-1}$ Signalen ($S_i$), wobei i eine positive ganze Zahl von 1 bis $2^{m-1}$ ist, die die gleiche Amplitude ($A_0$) aufweisen, auf den gleichen Mittelwert ($C_0$) zentriert sind und nacheinander um $2\pi/2^{m-1}$ in Bezug aufeinander phasenverschoben sind, wobei m eine positive ganze Zahl kleiner als oder gleich n ist, dazu bestimmt, mit einer Auflösung gleich $2^n$ die Position eines rotierenden Organs zu liefern, das fest mit dem beweglichen Ziel verbunden ist, **dadurch gekennzeichnet, dass** die Vorrichtung zur Verarbeitung darüber hinaus umfasst:

- Mittel (2) zur Erfassung von $2^m$ Sektoren ($P_i$), abgegrenzt durch die $2^{m-1}$ Signale ($S_i$), die m digitale Signale ($b_{n-m+1}$, $b_{n-m+2}$, ..., $b_{n-1}$, $b_n$) liefern, die den werthohen Bits des numerischen Ausgangssignals des Sensors entsprechen und die so codiert sind, dass sie die $2^m$ identischen Sektoren ($P_i$) definieren;

- Mittel (3) zum analogen Multiplexen der von den Erzeugungsmitteln (1) gelieferten $2^{m-1}$ Signale ($S_i$), die von den m digitalen Signalen ($b_{n-m+1}$, $b_n$) gesteuert werden, die von den Erfassungsmitteln (2) ausgegeben werden, und die zwei Signale (A und B) liefern, von denen das eine (A) gebildet wird durch die Aufeinanderfolge der Anteile der $2^{m-1}$ Signale ($S_i$), deren Amplitude zwischen dem Zentriermrert ($C_0$) und einem ersten Schwellenwert liegt ($L_1$) und von denen das andere (B) gebildet wird durch die Aufeinanderfolge der Anteile der $2^{m-1}$ Signale ($S_i$), deren Amplitude zwischen dem ersten Schwellenwert ($L_1$) und einem zweiten Schwellenwert ($L_2$) liegt, der höher ist als der erste ($L_1$);

- Mittel (4) zur Feininterpolation der zwei Signale (A und B), die von den Mitteln (3) zum Multiplexen ausgegeben wurden, in jedem der $2^m$ Sektoren ($P_i$), um (n-m) digitale Signale ($b_1$, $b_2$, ..., $b_{n-m-1}$, $b_{n-m}$) zu erzeugen, die den wertniedrigen Bits des numerischen Ausgangssignals entsprechen und die so codiert sind, dass sie jeden der $2^m$ Sektoren ($P_i$) mit einem Winkel von $2\pi/2^m$ in $2^{n-m}$ identische Untersektoren mit einem Winkel von $2\pi/2^n$ aufteilen, um die gewünschte Auflösung zu erzielen, wobei alle digitalen Ausgangssignale ($b_1$, ..., $b_{n-m}$, $b_{n-m+1}$, ..., $b_n$) des Positionssensors repräsentativ sind für die halbabsolute Position des rotierenden Organs.

3. Numerischer Sensor für die relative Position eines rotierenden Organs, umfassend eine Verarbeitungsvorrichtung nach Anspruch 1, **dadurch gekennzeichnet, dass** die Verarbeitungsvorrichtung darüber hinaus umfasst:

- Mittel (7) zur Erzeugung eines numerischen Ausgangssignals ($b_{QUAD}$), das zum numerischen Ausgangssignal ($b_1$), das dem wertniedrigsten Bit des Ausgangssignals des numerischen Positionssensors entspricht, um 90° phasenverschoben ist und von gleicher Auflösung wie dieses ist;

- Mittel (8) zur Erzeugung eines Referenzimpulses ($b_{TT}$);

wobei die digitalen Signale ($b_1$), ($b_{QUAD}$) und ($b_{TT}$) die relative Position des rotierenden Organs geben.

4. Numerischer Positionssensor nach einem der Ansprüche 1, 2 oder 3, **dadurch gekennzeichnet, dass** die Mittel (3) zum analogen Multiplexen die Signale (A und B) ausgehend von den Schwellenwerten ($L_1$) und ($L_2$) erzeugen, die bestimmte Werte aufweisen:

$$L_1 = A_0 * \sin(2\pi/2^m)$$

$$L_1 = A_0 * \sin(2\pi/2^{m-1})$$

5. Numerischer Positionssensor nach Anspruch 4, **dadurch gekennzeichnet, dass** die Mittel (3) zum analogen Multiplexen $2^m$ Kombinationen von logischen Schaltkreisen umfassen, wie die Gatter (11) NEIN und UND.

6. Numerischer Positionssensor nach einem der Ansprüche 1, 2 oder 3, **dadurch gekennzeichnet, dass** die Mittel (4) zur Feininterpolation Signale ($B_j$) erzeugen, wobei j eine ganze Zahl von 1 bis ($2^{n-m} - 1$) ist, die Dämpfungen des Signals (B) um Dämpfungsfaktoren ($k_j$) sind, deren Werte gleich

$$k_j = -\sin(j*2\pi/2^n) / \sin(j*2\pi/2^n - 2\pi/2^{m-1}) \text{ sind,}$$

jedes Signal ($B_j$) mit dem Signal (A) vergleichen und dann logische Kombinationen der digitalen Signale bilden, die aus diesen Vergleichen hervorgegangen sind, um die (n-m) digitalen Ausgangssignale ($b_1$, $b_2$, ..., $b_{n-m-1}$, $b_{n-m}$) zu liefern, die den wertniedrigen Bits des Signals entsprechen.

7. Numerischer Positionssensor nach einem der Ansprüche 1, 2 oder 3, dazu bestimmt, die Position eine rotierenden Organs mit einer Auflösung gleich $2^9$ zu liefern, **dadurch gekennzeichnet, dass** die Mittel (1) zur Erzeugung der Signale ($S_i$) der Verarbeitungsvorrichtung $2^{m-1} = 8$ Signale ($S_1$ bis $S_8$) erzeugen, die in Bezug aufeinander um 45° phasenverschoben sind, folgende Werte aufweisen:

$$S_7 = -S_1$$

$$S_5 = -S_2$$

$$S_3 = \frac{S_1 + S_2}{\sqrt{2}}$$

$$S_6 = -S_3$$

$$S_4 = \frac{S_1 - S_2}{\sqrt{2}}$$

$$S_8 = - S_4$$

und ausgehend von Summenbildungsschaltungen (7), Umkehrschaltungen (8) und Verstärkern (9) erzielt werden.

8. Numerischer Positionssensor nach Anspruch 7, **dadurch gekennzeichnet, dass** die Mittel (2) zur Erfassung der $2^m = 16$ Sektoren ($P_i$) vier Kombinationen ($C_6$ bis $C_9$) von Vergleichern (10) und Logikgattern (11) vom Typ UND und ODER umfassen, die folgende digitale Signale liefern:

$$b_9 = 1 \text{ wenn } S_7 > 0,$$

$$b_8 = 1 \text{ wenn } S_5 > 0,$$

$$b_7 = 1 \text{ wenn } (S_3 > 0 \text{ UND } S_4 > 0) \text{ ODER } (S_6 > 0 \text{ UND } S_8 > 0),$$

$$b_6 = 1 \text{ wenn } (S_1 > S_8 \text{ UND } S_2 > S_4) \text{ ODER } (S_5 > S_3 \text{ UND } S_1 > S_6)$$

$$\text{ODER } (S_7 > S_4 \text{ UND } S_5 > S_8) \text{ ODER } (S_2 > S_6 \text{ UND } S_7 > S_3).$$

9. Numerischer Sensor für die relative Position nach Anspruch 3, **dadurch gekennzeichnet, dass** die Mittel (7) zur Erzeugung eines numerischen Ausgangssignals ($b_{QUAD}$) ausgehend vom logischen Operator Exklusiv-ODER (XODER) folgende boolesche Operation ausführen:

$$b_{QUAD} = b_2 \text{ XODER } b_3 \text{ XODER } ... \text{ XODER } b_{n-1} \text{ XODER } b_n.$$

10. Numerischer Sensor für die relative Position nach Anspruch 3, **dadurch gekennzeichnet, dass** die Mittel (8) zur Erzeugung eines Referenzimpulses ($b_{TT}$) folgende boolesche Operation ausführen:

$$b_{TT} = b_1 \text{ UND } b_2 \text{ UND } .. \text{ UND } b_{n-1} \text{ UND } b_n.$$

11. Numerischer Sensor für die relative Position nach Anspruch 9 und 10, **dadurch gekennzeichnet, dass** die Mittel (7) zur Erzeugung eines numerischen Ausgangssignals ($b_{QuAD}$) durch eine logische Exklusiv-ODER-Schaltung gebildet werden, die am Eingang die digitalen Ausgangssignale ($b_2$ bis $b_n$) empfängt, mit Ausnahme des Signals ($b_1$), das dem wertniedrigsten Bit des Ausgangssignals des numerischen Positionssensors entspricht, und dass die Mittel (8) zur Erzeugung eines Referenzimpulses ($b_{TT}$) durch mehrere UND- und NEIN-Logikgatter gebildet werden.

12. Numerischer Positionssensor nach Anspruch 6, **dadurch gekennzeichnet, dass** die Mittel (4) zur Feininterpolation Widerstandsnetze umfassen, die das Signal (B) dämpfen.

13. Numerischer Positionssensor nach einem der Ansprüche 1, 2 oder 3, **dadurch gekennzeichnet, dass** die n digitalen Ausgangssignale ($b_i$) mittels eines Datenübertragungsprotokolls, das in die Verarbeitungsvorrichtung integriert ist, serialisiert werden.

14. Numerischer Positionssensor nach einem der Ansprüche 1 oder 2, **dadurch gekennzeichnet, dass** die Codierung der n digitalen Ausgangssignale ($b_1$ bis $b_n$) es ermöglicht, die absolute Position des Sensors ohne Mehrdeutigkeit zu definieren.

**Claims**

1. Digital position sensor constituted on the one hand by a mobile reference mark opposite a fixed analogue sensor composed of two sensitive elements delivering two sinusoidal output signals ($S_1$ and $S_2$) of equal maximum amplitudes ($A_0$) centred on a common average value ($C_0$), in quadrature and of a period equal to one turn of rotation of the reference mark, and on the other hand by a device for processing the two output signals ($S_1$ and $S_2$) generating n parallel digital output signals, n being a positive whole greater than or equal to 2, comprising means (1) for generating, from the two input signals ($S_1$ and $S_2$), $2^{m-1}$ signals ($S_i$), i being a positive whole number varying from 1 to $2^{m-1}$ of the same amplitude ($A_0$) centred on the same average value ($C_0$) and successively de-phased by $2\Pi/2^{m-1}$ with respect to one another, m being a whole positive number less than or equal to n, intended to deliver the position of a rotating member integral with the mobile reference mark, with a resolution equal to $2^n$, **characterised in that** the processing device comprises:

- means (2) for detecting $2^m$ sectors ($P_i$) delimited by the $2^{m-1}$ signals ($S_i$) delivering m digital signals ($b_{n-m+1}$, $b_{n-m+2}$, ..., $b_{n-1}$, $b_n$) that correspond to the high order bits of the digital output signal of the sensor and that are coded such as to define the $2^m$ identical sectors ($P_i$);

- means (3) for analogue multiplexing of the $2^{m-1}$ signals ($S_i$) delivered by the generating means (1), controlled by the m digital signals ($b_{n-m+1}$, $b_n$) output by the detection means (2) and delivering two signals (A and B), one of which (A) is constituted by the succession of the portions of the $2^{m-1}$ signals ($S_i$), the amplitude of which is between the centring value ($C_0$) and a first threshold ($L_1$), and the other of which (B) is constituted by the succession of portions of $2^{m-1}$ signals ($S_i$), the amplitude of which is between the first threshold ($L_1$) and a second threshold ($L_2$) greater than ($L_1$);

- means (4) for fine interpolation of the two signals (A and B) output by the multiplexing means (3) in each of the $2^m$ sectors ($P_i$) in order to generate (n-m) digital signals ($b_1$, $b_2$, .. $b_{n-m-1}$, $b_{n-m}$) that correspond to the low order bits of the signal and that are coded such as to split each of the $2^m$ sectors ($P_i$) of an angle $2\Pi/2^m$ into $2^{n-m}$ identical sub-sectors of an angle $2\Pi/2^n$ in order to obtain the desired resolution, the entirety of the digital output signals ($b_1$, ..., $b_{n-m}$, $b_{n-m+1}$, ..., $b_n$) of the position sensor being representative of the absolute position of the rotating member.

2. Digital position sensor constituted on the one hand by a mobile multipolar reference mark opposite a fixed analogue sensor composed of two sensitive elements delivering two sinusoidal output signals ($S_1$ and $S_2$) of equal maximum amplitudes ($A_0$) centred on a common average value ($C_0$), in quadrature and of a period equal to $2k\Pi$ turns of rotation of the reference mark, k being a whole positive number greater than or equal to 2, and on the other hand by a device for processing the two output signals ($S_1$ and $S_2$) generating n parallel digital output signals, n being a positive whole greater than or equal to 2, comprising means (1) for generating, from the two input signals ($S_1$ and $S_2$), a number of signals ($S_i$) equal to $2^{m-1}$, being a positive whole number varying from 1 to $2^{m-1}$, of the same amplitude ($A_0$) centred on the same average value ($C_0$) and successively de-phased by $2\Pi/2^{m-1}$ with respect to one another, m being a whole positive number less than or equal to n, intended to deliver the position of a rotating member integral with the mobile reference mark, with a resolution equal to $2^n$, **characterised in that** the processing means further comprises:

- means (2) for detecting $2^m$ sectors (Pi) delimited by the $2^{m-1}$ signals ($S_i$) delivering m digital signals ($b_{n-m-1}$, $b_{n-m+2}$, ..., $b_{n-1}$, $b_n$) that correspond to the high order bits of the digital output signal of the sensor and that are coded such as to define the $2^m$ identical sectors ($P_i$);

- means (3) for analogue multiplexing of the $2^{m-1}$ signals (Si) delivered by the generating means (1) controlled by the m digital signals ($b_{n-m+1}$, $b_n$) output by the detection means (2) and delivering two signals (A and B), one of which (A) is constituted by the succession of the portions of the $2^{m-1}$ signals ($S_i$), the amplitude of which is between the centring value ($C_0$) and a first threshold ($L_1$), and the other of which (B) is constituted by the succession of portions of $2^{m-1}$ signals ($S_i$), the amplitude of which is between a first threshold ($L_1$) and a second threshold ($L_2$) greater than ($L_1$);

- means (4) for fine interpolation of the two signals (A and B) output by the multiplexing means (3) in each of the $2^m$ sectors ($P_i$) in order to generate (n-m) digital signals ($b_1$, $b_2$, ..., $b_{n-m-1}$, $b_{n-m}$) that correspond to the low order bits of the signal and that are coded such as to split each of the $2^m$ sectors ($P_i$) of an angle $2\Pi/2^m$ into $2^{n-m}$ identical sub-sectors of an angle $2\Pi/2^n$ in order to obtain the desired resolution, the entirety of the digital output signals ($b_1$, ..., $b_{n-m}$, $b_{n-m+1}$, ..., $b_n$,) of the position sensor being representative of the absolute position of the rotating member.

**3.** Digital sensor of the relative position of a rotating member, comprising a processing device according to claim 1, **characterised in that** the processing device also comprises:

- means (7) for generating a digital output signal ($b_{QUAD}$) in quadrature with the digital output signal ($b_1$) corresponding to the lowest order bit of the output signal of the digital position sensor, and of the same resolution thereof;

- means (8) for generating a reference pulse ($b_{TT}$),

said digital signals ($b_1$), ($b_{QUAD}$) and ($b_{TT}$) giving the relative position of the rotating member.

**4.** Digital position sensor according to one of claims 1, 2 or 3, **characterised in that** the analogue multiplexing means (3) generating the signals (A and B) for thresholds ($L_1$) and ($L_2$) of established values:

$$L_1 = A_0 * \sin(2\pi/2^m)$$

$$L_2 = A_0 * \sin(2\Pi/2^{m-1}).$$

**5.** Digital position sensor according to claim 4, **characterised in that** the analogue multiplexing means (3) comprise $2^m$ combinations of logic circuits, such as NOT and AND gates (11).

**6.** Digital position sensor according to one of claims 1, 2 or 3, **characterised in that** the fine interpolation means (4) generate signals ($Bj$), j being a whole number varying from 1 to ($2^{n-m-1}$), that are attenuations of the signal (B) by attenuation factors ($kj$) of values equal to:

$$kj = -\sin(j*2\Pi/2^n)/\sin(j*2\Pi/2^n - 2\Pi/2^{m-1})$$

compare each signal ($Bj$) to the signal (A), then form logical combinations of the digital signals resulting from these comparisons in order to deliver the (n-m) digital output signals ($b_1$, $b_2$, .., $b_{n-m-1}$, $b_{n-m}$) corresponding to the low order bits of the signal.

**7.** Digital position sensor according to one of claims 1, 2 or 3, intended to deliver the position of a rotating member with a resolution equal to $2^9$, **characterised in that** the means (1) for generating signals ($S_i$) of the processing device generate $2^{m-1}=8$ signals ($S_1$ to $S_8$), de-phased by 45° with respect to one another, having values of

$$S_7 = -S_1$$

$$S_5 = -S_2$$

$$S_3 = \frac{S_1 + S_2}{\sqrt{2}}$$

$$S_6 = -S_3$$

$$S_4 = \frac{S_1 - S_2}{\sqrt{2}}$$

$$S_8 = -S_4$$

obtained from adder circuits (7), inverter circuits (8) and amplifiers (9).

8. Digital position sensor according to claim 7, **characterised in that** the means (2) for detecting the $2^m = 16$ sectors ($P_i$) comprise four combinations ($C_6$ to $C_9$) of comparators (10) and logic gates (11) of the AND and OR type, delivering the following digital signals:

$$b_9 = 1 \text{ if } S_7 > 0,$$

$$b_8 = 1 \text{ if } S_5 > 0,$$

$$B_7 = 1 \text{ if } (S_3 > 0 \text{ AND } S_4 > 0) \text{ OR } (S_6 > 0 \text{ AND } S_8 > 0),$$

$$b_6 = 1 \text{ if } (S_1 > S_8 \text{ AND } S_2 > S_4) \text{ OR } (S_5 > S_3 \text{ AND } S_1 > S_6) \text{ OR } (S_7 > S_4 \text{ AND } S_5 > S_8)$$

$$\text{OR } (S_2 > S_6 \text{ AND } S_7 > S_3).$$

9. Digital relative position sensor according to claim 3, **characterised in that** the means (7) for generating a digital output signal ($b_{QUAD}$) perform the following Boolean operation, from the exclusive OR logical operator (ORX):

$$b_{(QUAD)} = b_2 \text{ ORX } b_3 \text{ ORX } ... \text{ ORX } b_{n-1} \text{ ORX } b_n.$$

10. Digital relative position sensor according to claim 3, **characterised in that** the means (8) for generating a reference pulse ($b_{TT}$) perform the following Boolean operation:

$$b_{TT} = b_1 \text{ AND } b_2 \text{ AND } ... \text{ AND } b_{n-1} \text{ AND } b_n.$$

11. Digital relative position sensor according to claims 9 and 10, **characterised in that** the means (7) for generating a digital output signal ($b_{QuAD}$) are constituted by an exclusive OR logic circuit receiving at its input the digital output signals ($b_2$ to $b_n$), except the signal ($b_1$) corresponding to the lowest order bit of the output signal of the digital position sensor, and **in that** the means (8) for generating a reference pulse ($b_{TT}$) are constituted by a plurality of AND and NOT logic gates.

12. Digital position sensor according to claim 6, **characterised in that** the means (4) for fine interpolation comprise impedance networks attenuating the signal (B).

13. Digital position sensor according to one of claims 1, 2 or 3, **characterised in that** the n digital output signals ($b_i$) are serialised by means of a data transmission protocol integrated into the processing device.

14. Digital position sensor according to one of claims 1 or 2, **characterised in that** the coding of the n digital output signals ($b_1$ to $b_n$) allow unambiguous definition of the absolute position of the sensor.

FIG_1

FIG_2

S1

S2

23  45  68  90  113  135  158  180  203  225  248  270  293  315  338

EP 1 017 966 B1

FIG_3

18

S2　　　S3　　　S1　　　S4　　　S5　　　S6　　　S7　　　S8

A₀

B　　L1　　L2

P1　　P3　　A　　P13　　P15

C₀

P2　　P4　　P14　　P16

## Figure 4a

## Figure 4b

b9

b8

b7

b6

0　23　45　68　90　113　135　158　180　203　225　248　270　293　315　338

FIG_5

FIG_6

# FIG_7a

FIG_7b

FIG_7c

FIG_7d

FIG_8

FIG_9

FIG_10

# FIG_11

FIG_12a

FIG_12b

FIG_13

EP 1 017 966 B1

FIG_14